(19) Europäisches Patentamt
European Patent Office
Office européen des brevets

(11) EP 2 278 504 A1

(12) DEMANDE DE BREVET EUROPEEN

(43) Date de publication:
26.01.2011 Bulletin 2011/04

(51) Int Cl.:
*G06F 17/50* (2006.01)

(21) Numéro de dépôt: 10169331.5

(22) Date de dépôt: 13.07.2010

(84) Etats contractants désignés:
AL AT BE BG CH CY CZ DE DK EE ES FI FR GB GR HR HU IE IS IT LI LT LU LV MC MK MT NL NO PL PT RO SE SI SK SM TR
Etats d'extension désignés:
BA ME RS

(30) Priorité: 17.07.2009 FR 0954988

(71) Demandeur: Airbus Operations (S.A.S.)
31060 Toulouse (FR)

(72) Inventeur: Minot, Frédéric
31810 Venerque (FR)

(74) Mandataire: Augarde, Eric
BREVALEX
56 Boulevard de l'Embouchure,
Bât. B
B.P. 27519
31075 Toulouse Cedex 2 (FR)

(54) **Méthode de routage des liaisons physiques d'une plateforme avionique**

(57) L'invention concerne une méthode de routage de liaisons physiques d'une plateforme avionique au sein d'un aéronef. Une liaison physique relie une pluralité ($N$) d'équipements et est composée d'une ou plusieurs branche(s), chaque branche de ladite liaison reliant l'équipement source un équipement destinataire. La méthode proposée permet de minimiser la longueur totale du câblage de la plateforme et, le cas échéant, de choisir entre différentes positions des équipements au sein de l'aéronef et/ou différents graphes de routage.

Projection des points source et destinataire(s) sur le graphe de routage
Extension du graphe de routage à ces points — 1010

↓

Pour chaque branche détermination du plus court chemin dans le graphe de routage. — 1020

↓

Elimination des segments redondants entre les différents chemins: obtention de chemins élagués. — 1030

↓

Recherche des points de dérivation — 1040

↓

Détermination des câbles et installation des câbles selon les chemins de routage — 1050

**Fig. 10**

## Description

## DOMAINE TECHNIQUE

La présente invention concerne de manière générale le domaine des plateforme avioniques et plus précisément celles qui sont réalisées selon une architecture modulaire intégrée, dite IMA (*Integrated Modular Avionics*) .

## ÉTAT DE LA TECHNIQUE ANTÉRIEURE

La réalisation d'une plateforme avionique, c'est-à-dire de l'ensemble des moyens de calcul et de communication embarqués permettant d'exécuter les fonctions d'un aéronef fait traditionnellement appel à des calculateurs et des bus de communication dédiés. Dans une telle plateforme, chaque fonction de l'aéronef, dénommée ci-après fonction avionique, est implémentée à l'aide de calculateurs ayant une architecture et des entrées-sorties spécifiques à la réalisation de la fonction. Ceci implique de réaliser, certifier et maintenir un grand nombre de composants ou LRUs *(Line Replaceable Units),* et ce à chaque fois qu'un nouveau type d'appareil doit être conçu.

Pour remédier à cette source de complexité et de coûts, les plateformes avioniques de nouvelle génération utilisent, autant que faire se peut, une architecture modulaire intégrée (IMA). Dans ce type d'architecture, les fonctions avioniques sont implémentées dans des ressources partagées, en pratique sous forme de modules logiciel hébergés par des calculateurs génériques, et utilisant des moyens de communication non dédiés. Une telle plateforme présente de nombreux avantages en termes de réduction de la quantité de calculateurs, du nombre de types différents de calculateurs, de nombre de câbles, etc., ce qui se traduit en définitive par un bilan de masse plus favorable et d'importants gains en matière de maintenance et de gestion des stocks.

Toutefois, alors que les plateformes avioniques traditionnelles étaient réalisées de manière empirique, à l'aide de règles fondées sur l'expérience et en procédant par de nombreux allers-retours entre phase de conception et phase de validation, les plateformes de nouvelle génération requièrent une approche entièrement différente, ce tant en raison de leur complexité que du partage de ressources entre fonctions avioniques, inhérent à l'architecture IMA. Par exemple, alors que les défaillances matérielles concomitantes d'équipements fonctionnels étaient autrefois évitées en utilisant des ressources de calcul et de communication dédiées, l'architecture IMA ne permet pas de garantir cette robustesse de manière intrinsèque. Il est donc nécessaire de répartir judicieusement les modules logiciel dans les calculateurs génériques et de s'assurer que les moyens de communication permettent d'assurer les échanges entre ces modules.

Une fois les modules logiciels répartis dans les calculateurs génériques, il est nécessaire de relier ces derniers entre eux, soit au moyen de liaisons physiques directes, soit au moyen d'un ou de plusieurs réseaux, afin que les modules logiciels puissent communiquer selon un schéma fonctionnel prédéterminé. Les réseaux sont eux-mêmes constitués de noeuds de communication tels que commutateurs, routeurs, passerelles, reliés entre eux par des liaisons réseau. L'installation de la plateforme avionique suppose de router un grand nombre de liaisons physiques au sein de l'aéronef, chaque liaison physique reliant une occurrence d'équipement source à une ou plusieurs occurrence(s) d'équipement destinataires, chacune desdites occurrences d'équipement destinataires étant reliée à l'occurrence d'équipement source au moyen d'une branche de ladite liaison physique, chaque branche de liaison physique étant réalisée à l'aide d'un câble ou de plusieurs câbles connectés bout à bout. Le routage des liaisons physiques revient à définir les câbles qui les constituent et leur routage dans la structure de l'aéronef. Par routage d'un câble on entend le choix d'un chemin tridimensionnel à l'intérieur de l'aéronef, désigné ci-après par chemin de routage.

Classiquement, chaque câble relatif à une liaison physique se voit attribuer un chemin de routage en fonction des positions des équipements qu'il doit interconnecter, les caractéristiques des signaux qu'il doit transporter ainsi que des critères de ségrégation. On comprend par exemple que les câbles destinés à transporter des données et les câbles d'alimentation empruntent des chemins distincts et que certains câbles transportant des informations redondantes doivent être ségrégués pour des raisons de sécurité. Les méthodes traditionnelles de routage sont toutefois généralement empiriques et ne permettent pas de minimiser de manière optimale la longueur du câblage.

Le but de la présente invention est de proposer une méthode de routage de liaison physique qui permette de réduire sensiblement la longueur de câblage d'une plateforme avionique de type IMA et par conséquent d'améliorer le bilan de masse de l'aéronef.

Un second but de la présente invention est de permettre d'évaluer le routage des liaisons physiques dans une plateforme avionique d'architecture donnée au regard du critère de la longueur de câblage.

Un troisième but de la présente invention est de permettre de comparer des plateformes avioniques relatives à un même aéronef mais d'architectures distinctes, en termes d'optimalité de routage des liaisons physiques.

Un but subsidiaire de la présente invention est de permettre d'évaluer, pour un routage donné de liaisons physiques, l'impact d'une perte d'un élément du câblage ou d'une occurrence d'équipement sur les fonctions avioniques de l'aéronef.

## EXPOSÉ DE L'INVENTION

La présente invention est définie par une méthode de routage par ordinateur d'une liaison physique d'une plateforme avionique à l'intérieur d'un aéronef, ladite liaison physique reliant une pluralité d'équipements physiques et étant composée d'une ou plusieurs branche (s), chaque branche de ladite liaison reliant un équipement source à un équipement destinataire de ladite pluralité. Selon cette méthode :

- les positions des équipements source et destinataire sont projetées sur au moins un graphe de routage prédéterminé au sein de l'aéronef et l'on étend ce graphe aux points définis par ces positions et par leurs projections respectives sur le graphe ;
- on détermine, pour chaque branche de ladite liaison, le chemin le plus court, à travers le graphe ainsi étendu, entre les équipements source et destinataire qu'elle relie, ledit chemin, dit chemin de routage, étant défini par une liste ordonnée de segments entre ces équipements ;
- on élimine les segments redondants entre les chemins de routage pour obtenir des chemins élagués ;
- on détermine des points de dérivation comme les extrémités de segment communes à aux moins trois segments desdits chemins élagués ;
- on définit à partir de chaque chemin élagué un ensemble de câbles dont les extrémités sont situées soit en un point d'équipement soit en un point de dérivation, lesdits câbles étant routés selon le chemin de routage.

Les câbles sont avantageusement définis en concaténant, pour chaque chemin élagué, les segments qui le constituent, l'opération de concaténation progressant dans le sens de la branche et étant interrompue à chaque fois que l'on atteint un point de dérivation ou bien un équipement destinataire, un câble étant défini par les segments concaténés entre deux interruptions successives.

Pour chaque branche, le chemin le plus court au sein du graphe de routage entre l'équipement source et l'équipement destinataire est obtenu de préférence par l'algorithme de Dijkstra.

La méthode de routage utilise avantageusement :

- une première base de données, dans laquelle est stockée une représentation d'au moins ledit graphe de routage, ledit graphe de routage étant défini par ses sommets et par les arêtes qui relient ces sommets ;
- une seconde base de données, dans laquelle est stockée une représentation des liaisons physiques de la plateforme avionique et, pour chaque liaison physique, des différentes branches qui la composent.

On peut en outre stocker dans une troisième base de données une représentation des câbles reliant les équipements, et dans une quatrième base de données, le chemin de routage associé à chaque câble.

Le cas échéant, la méthode de routage stocke également une représentation desdits points de dérivation.

La première base de données peut comprendre en outre une représentation des points de coupure, un point de coupure étant défini comme l'intersection d'un chemin de routage avec le plan d'aboutage de deux tronçons consécutifs composant l'aéronef.

Le routage est avantageusement effectué pour toutes les liaisons physiques de la plateforme avionique et l'on calcule une longueur totale de câblage comme la somme des longueurs des câbles obtenus pour toutes les liaisons physiques, la longueur d'un câble étant déterminée comme la somme des longueurs des segments qui le constituent.

Le routage peut être répété pour différentes positions des équipements, et l'on sélectionne alors l'ensemble des positions de ces équipements qui conduisent à la plus faible longueur totale de câblage.

De manière similaire, le routage peut être répété pour différents graphes de routage, et l'on sélectionne alors le graphe de routage qui conduit à la plus faible longueur totale de câblage.

Selon une variante, le routage est répété pour différentes positions des équipements et/ou différents graphes de routage, et l'on sélectionne l'ensemble des positions de ces équipements et/ou le graphe de routage qui conduisent au plus faible nombre de points de coupure.

Enfin dans un mode particulier de réalisation, on simule un accident de l'aéronef et l'on détermine une première liste de câbles (*CAB_L*) impactés par cet accident, à partir des points du graphe de routage eux-mêmes impactés, et/ou une seconde liste d'équipements (*EQ_L*) impactés par cet accident. On en déduit ensuite :

- un premier ensemble (*FO_L*) de modules logiciels hébergés par lesdits équipements de la seconde liste ;
- un second ensemble (*FLO_L*) de liens fonctionnels entre modules logiciels, lesdits liens fonctionnels étant affectés soit en raison d'un module logiciel auquel ils sont reliés, appartenant au premier ensemble, soit en raison d'un câble de la première liste supportant une liaison topologique utilisée par lesdits liens fonctionnels.

**BRÈVE DESCRIPTION DES DESSINS**

D'autres caractéristiques et avantages de l'invention apparaîtront à la lecture de modes de réalisation préférentiels de l'invention en référence aux figures jointes parmi lesquelles :

La Fig. 1 donne une représentation schématique orientée objet des fonctions avioniques d'un aéronef ;

La Fig. 2 donne une représentation schématique orientée objet d'une plateforme avionique ;

Les Fig. 3A à 3C montre les relations entre lien topologique, liaison physique et branche de liaison physique ;

La Fig. 4 représente de manière schématique l'implémentation des fonctions avioniques sur la plateforme avionique ;

La Fig. 5 donne une représentation schématique orientée objet de l'installation d'une plateforme avionique dans un aéronef ;

La Fig. 6 représente l'association entre la représentation de la plateforme avionique et celle de son installation dans l'aéronef ;

La Fig. 7 donne un exemple d'un graphe de routage et de chemins de routage dans un aéronef ;

La Fig. 8 donne un exemple de chemins de câble dans un aéronef ;

Les Figs. 9A et 9B illustrent différents routages possibles pour une liaison physique d'une plateforme avionique ;

La Fig. 10 représente l'organigramme de la méthode de routage d'une liaison physique selon un mode de réalisation de l'invention.

## EXPOSÉ DÉTAILLÉ DE MODES DE RÉALISATION PARTICULIERS

En préalable à l'exposé de la méthode de routage selon l'invention, nous décrirons ci-après une plateforme avionique selon une architecture modulaire intégrée. Cette plateforme est destinée à mettre en oeuvre un ensemble de fonctions avioniques prédéterminées. A titre d'exemple, ces fonctions avioniques peuvent être le contrôle du roulis de l'avion, le calcul de la quantité de carburant, etc.

A chacune de ces fonctions avioniques, on associe en règle générale une pluralité de modules logiciel qui sont destinés à être hébergés dans des calculateurs génériques embarqués et dont chacun participe à la réalisation de la fonction. Pour des raisons de sûreté, certaines fonctions peuvent être dupliquées. Les modules logiciel de fonctions dupliquées ne sont pas nécessairement identiques. Par exemple, deux tels modules logiciel peuvent correspondre à une voie de commande (COM) et une voie de surveillance (MON) d'un système de contrôle de vol et utiliser des algorithmes différents pour réaliser la même fonction.

Les modules logiciel associés aux différentes fonctions avioniques peuvent échanger des messages entre eux via des liens, dénommés « occurrences de lien fonctionnel », comme nous le verrons ci-après. Par exemple, un module logiciel réalisant la fonction de contrôle de roulis peut transmettre un message d'alerte à un module logiciel en charge de la fonction d'affichage.

L'ensemble des fonctions avioniques d'un aéronef ainsi que leurs relations entre elles peuvent avantageusement être représentées à l'aide d'une modélisation objet.

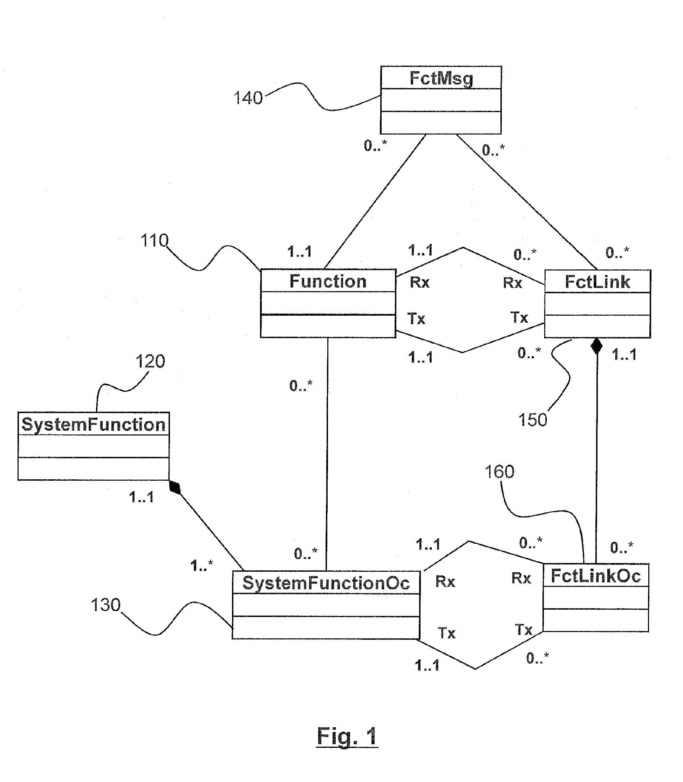

La Fig. 1 donne un diagramme UML *(Unified Modeling Language)* modélisant la structure de données et les relations entre fonctions avioniques d'un aéronef. On trouvera par exemple une description du langage UML dans l'ouvrage de F. Barbier intitulé « UML2 et MDE » publié chez Dunod.

Le modèle représenté comprend les objets (ou classes) dénommés « Function », « SystemFunction », « SystemFunctionOc », « FctMsg », « FctLink » et « FctLinkOc ». Pour des raisons de simplification, les attributs et les méthodes relatifs aux différents objets ont été omis là où ils n'apparaissaient pas nécessaires à la bonne compréhension de l'invention.

L'objet « Function », 110, correspond à une fonction avionique. Cet objet est associé avec une multiplicité quelconque à des objets « SystemFunctionOc », 130, explicités ci-après. Une fonction peut transmettre un nombre quelconque de messages, au moyen d'un lien symbolique, dénommé lien fonctionnel, à une autre fonction. Ainsi, l'objet « Function », 110, est associé à 0 à N objets « Fctmsg », 140, décrivant les messages en question. Chaque lien fonctionnel, modélisé par l'objet « FctLink », 150, est associé à une fonction avionique émettrice et une fonction avionique destinataire. Réciproquement, à une fonction peuvent être associés un nombre quelconque de liens entrants ainsi qu'un nombre quelconque de liens sortants. En outre, un lien fonctionnel peut voir transiter un nombre quelconque de messages et, réciproquement, un message d'une fonction avionique peut être transmis sur un nombre quelconque de liens fonctionnels.

Chaque lien fonctionnel 150, est instanciable et composé de 0 à N occurrences de lien fonctionnel, 160. Les occurrences de lien fonctionnel désignés par l'objet « FctLinkOc ».

L'objet « SystemFunction », désigné par 120, est composé d'au moins une occurrence « SystemFunctionOc », 130. L'objet 130 peut être considéré en pratique comme un module logiciel destiné à être hébergé par un équipement, l'objet 120 représentant alors une classe de tels modules logiciels. L'objet 130 est associé à un nombre quelconque d'occurrences de lien fonctionnel entrant, ainsi qu'à un nombre quelconque de lien fonctionnel sortant. Réciproquement, une occurrence de lien fonctionnel est associée à un module logiciel émetteur et un module logiciel destinataire.

Le modèle représenté en Fig. 1 permet de donner une représentation fonctionnelle de plateforme avionique. La plateforme avionique également peut faire l'objet d'une représentation matérielle.

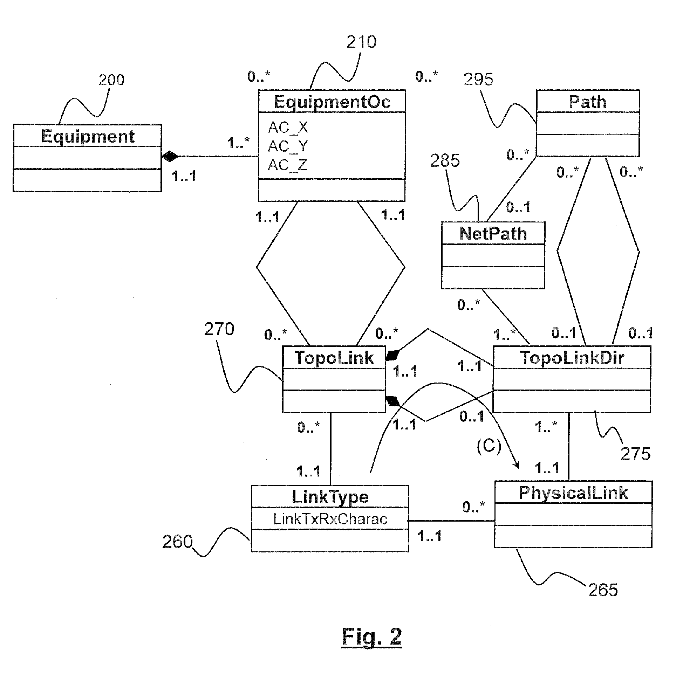

La Fig. 2 donne, sous forme d'un diagramme UML, la structure de données de cette représentation.

Dans le cadre de la présente invention, la structure matérielle d'une plateforme avionique est généralement décrite à l'aide d'objets dénommés « Equipment », « EquipmentOc », « TopoLink », « TopoLinkDir », « NetPath », « Path », « Physical Link » définis ci-après.

La brique de base de cette structure matérielle est l'objet « Equipment », 200, lui-même composé par une ou des occurrence(s) d'équipement, 210. Concrètement, l'objet « Equipment » représente une classe constituée d'éléments matériels tels que des calculateurs, des capteurs, des actuateurs, des commutateurs, des routeurs, des passerelles etc. Un équipement peut être plus généralement considéré comme un élément matériel disposant de ressources de calcul et/ou de communication. Chaque occurrence d'équipement, 210, hérite des attributs de l'objet « Equipment » notamment de ses ressources matérielles, comme nous le verrons plus loin. Il est en outre caractérisé par des attributs propres, notamment sa position dans l'aéronef, donnée ici en coordonnées cartésiennes par rapport à un repère donné.

L'objet « PhysicalLink », 265, représente les liaisons physiques, indépendamment du réseau auquel elles appartiennent éventuellement. Une liaison physique permet de relier une occurrence d'équipement à une ou plusieurs autres occurrence(s) d'équipement. Chaque liaison physique peut être constituée d'une ou de plusieurs branches de liaisons physiques, une branche de liaison physique reliant une occurrence d'équipement à une seule autre occurrence d'équipement.

L'objet « TopoLink » ou lien topologique, 270, est une entité abstraite indiquant la possibilité de connecter deux occurrences d'équipement au moyen d'une liaison physique, de manière unidirectionnelle ou bidirectionnelle. A partir de cet objet on définit un lien topologique orienté, soit « TopoLinkDir », 275, chaque lien topologique étant composé soit d'un, soit de deux liens topologiques orientés. L'objet « TopoLinkDir » peut être considérée de manière équivalente comme une branche de liaison physique.

On définit encore l'objet de chemin réseau « NetPath », 285, comme une liste ordonnée et connexe de liens topologiques orientés entre des noeuds de réseau de communication. Il est important de souligner que les liaisons physiques sous-jacentes à ces liens topologiques orientés n'appartiennent pas nécessairement à un même réseau. Un chemin réseau comprend au moins un lien topologique et, inversement, un lien topologique orienté peut faire partie d'un nombre quelconque de chemins réseau, voire d'aucun chemin réseau si ce lien est isolé.

Enfin, on définit un objet plus général, dit « Path » ou chemin topologique, 295, pouvant relier deux occurrences quelconques d'équipement de la plateforme avionique. Un tel chemin est constitué soit d'un lien topologique orienté dans l'un ou l'autre sens (autrement dit, les occurrences d'équipement sont reliées par une simple liaison physique), soit d'un chemin réseau auquel est adjoint, à l'une ou à ses deux extrémité(s), un lien topologique orienté.

Le modèle représenté en Fig. 2 permet de stocker la représentation matérielle de la plateforme avionique dans une base de données, dite base de données matérielle.

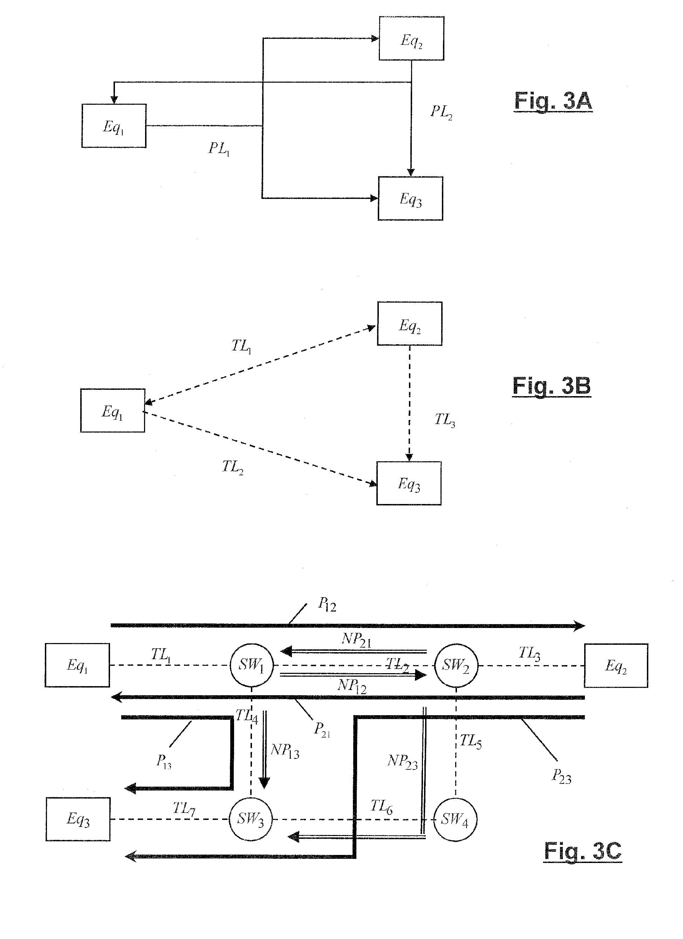

A titre d'illustration, nous avons donné en Figs. 3A à 3C des exemples de liaisons physiques, de branches de liaisons physiques, de liens topologiques, de chemins réseau et de chemins topologiques entre différents équipements.

On a représenté sur ces figures trois équipements (plus rigoureusement, selon la terminologie objet, trois occurrences d'équipement) $Eq_1, Eq_2, Eq_3$.

En Fig. 3A, l'équipement $Eq_1$ est relié aux équipements $Eq_2, Eq_3$ à l'aide d'une première liaison physique $PL_1$ de type multicast ($1 \Rightarrow N$). De même, l'équipement $Eq_2$ est relié aux équipements $Eq_1, Eq_3$, à l'aide d'une seconde liaison physique $PL_2$ de type multicast. La liaison physique $PL_1$ est constituée des deux branches de liaison physique $BPL_1^1$ et $BPL_1^2$, reliant $Eq_1$ respectivement à $Eq_2$ et $Eq_3$. De même la liaison physique $PL_2$ est constituée des deux branches de liaison physique $BPL_2^1$ et $BPL_2^2$, reliant $Eq_2$ respectivement à $Eq_1$ et $Eq_3$.

La Fig. 3B représente les liens topologiques $TL_1$, $TL_2$, $TL_3$ associés aux liaisons physiques de la Fig. 3A.

Plus précisément, le lien topologique $TL_1$ entre les équipements $Eq_1$ et $Eq_2$ est associé aux liaisons physiques $PL_1$ et $PL_2$ entre ces deux équipements. Le lien topologique $TL_1$ est en fait composé d'un premier lien topologique orienté entre $Eq_1$ et $Eq_2$ et d'un second lien topologique orienté, de sens inverse. Les liens topologiques $TL_2$ et $TL_3$ sont respectivement associés aux liaisons physiques $PL_1$ et $PL_2$. Ils sont constitués chacun d'un seul lien topologique orienté. La Fig. 3C représente trois équipements $Eq_1, Eq_2, Eq_3$ reliés à l'aide d'un réseau AFDX comprenant quatre commutateurs $SW_1, ..., SW_4$. On a désigné par $TL_1$ à $TL_7$ les différents liens topologiques bidirectionnels (liaisons physiques sous-jacentes de type monocast $1 \Leftrightarrow 1$), chaque lien topologique $TL_i$ étant constitué de deux liens topologiques orientés $TL_i^+$ et $TL_i^-$ (le sens positif a été conventionnellement choisi ici comme le sens horaire). On a également indiqué les chemins réseau $NP_{12}$ $NP_{21}$, $NP_{13}$, $NP_{23}$, définis respectivement par

$$NP_{12} = \left\{ TL_2^+ \right\} \quad ; \quad NP_{21} = \left\{ TL_2^- \right\} \quad ;$$

$$NP_{13} = \left\{ TL_4^+ \right\} ; \quad NP_{23} = \left\{ TL_5^+, TL_6^+ \right\} .$$ Le chemin topologique $P_{12}$ qui relie l'équipement $Eq_1$ à l'équipement $Eq_2$ est alors constitué par

$P_{12} = \left\{ TL_1^+, NP_{12}, TL_3^+ \right\}$. De manière similaire, le chemin topologique $P_{21}$ qui relie l'équipement $Eq_2$ à l'équipement $Eq_1$ est constitué par

$P_{21} = \left\{ TL_3^-, NP_{21}, TL_1^- \right\}$. Le chemin topologique $P_{13}$, reliant l'équipement $Eq_1$ à $Eq_3$, et celui $P_{23}$ reliant l'équipement $Eq_2$ à $Eq_3$ sont respectivement constitués par

$P_{13} = \left\{ TL_1^+, NP_{13}, TL_7^+ \right\}$ et

$P_{23} = \left\{ TL_3^-, NP_{23}, TL_7^+ \right\}$.

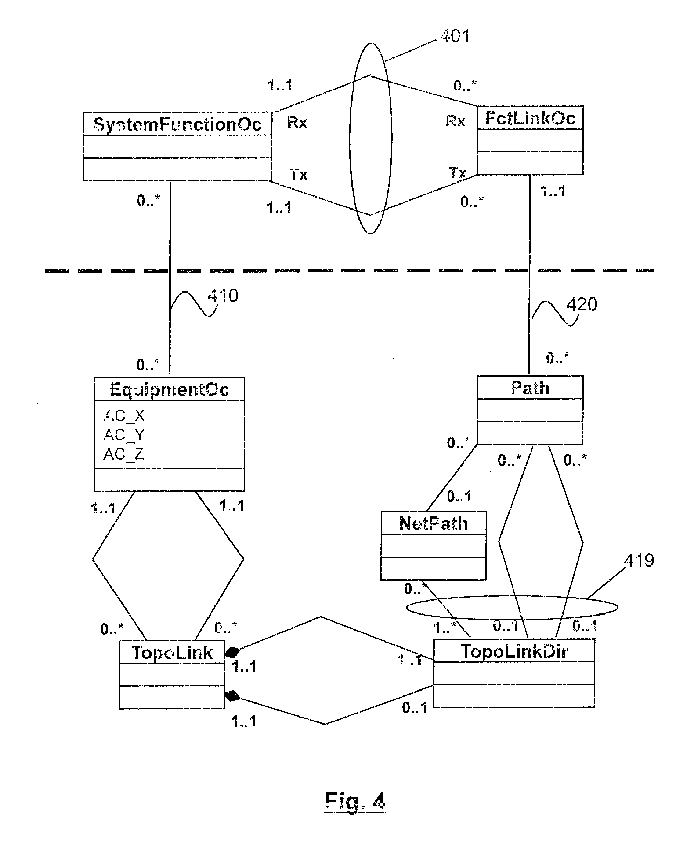

La Fig. 4 représente de manière schématique l'implémentation des fonctions avioniques sur la plateforme avionique.

On retrouve sur cette figure une partie du modèle de la structure fonctionnelle de la plateforme et une partie du modèle de sa structure matérielle, séparées schématiquement par un trait discontinu. La réalisation de la plateforme consiste à associer d'une part chaque objet « SystemFunctionOc » c'est-à-dire à chaque module logiciel d'une fonction avionique, une occurrence d'équipement « EquipmentOc » destinée à l'héberger et, d'autre part, à tout lien fonctionnel « FctLinkOc » un ou plusieurs chemin(s) destiné(s) à faire transiter les messages fonctionnels entre les modules logiciel relatifs aux fonctions avioniques.

L'implémentation matérielle des fonctions avioniques dans la plateforme se traduit dans le diagramme par les relations d'association 410 et 420.

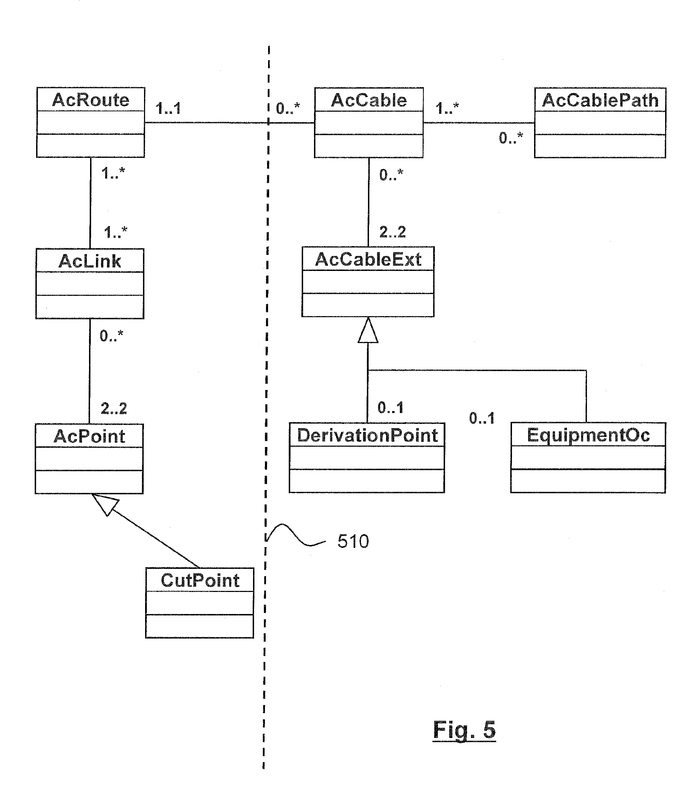

La Fig. 5 donne une représentation UML d'un modèle de données décrivant l'installation de la plateforme avionique dans l'aéronef.

Ce modèle comprend d'une part des objets relatifs aux chemins de routage ; « AcRoute », « AcLink », « AcPoint » et « CutPoint » et d'autre part des objets relatifs au câblage de la plateforme avionique :

« AcCable », « AcCableExt », « AcCablePath » et « DerivationPoint ».

L'objet « AcRoute » représente un graphe de routage non orienté, le terme graphe étant compris ici au sens de la théorie des graphes. Ce graphe de routage peut être un arbre c'est à dire un graphe non orienté, acyclique et connexe. De manière générale le graphe de routage peut être défini comme un ensemble connexe de segments géométriques (des arêtes du graphe), représentés par « AcLink », chaque segment géométrique étant bien entendu défini par ses deux extrémités (des sommets du graphe). Chaque extrémité est un point géométrique à l'intérieur de l'aéronef représenté par « AcPoint » et possède pour attributs ses coordonnées cartésiennes en X, Y, Z par rapport au repère évoqué *supra* en relation avec la Fig. 2. Parmi certaines extrémités de segments, on distingue des points de coupure représentés par l'objet « CutPoint ». On appelle point de coupure d'un arbre de routage tout point à l'intersection de cet arbre et d'une section délimitant deux tronçons consécutifs de l'aéronef. Par exemple, si le fuselage de l'aéronef est constitué de plusieurs tronçons assemblés bout à bout, les points de coupure seront situés dans des plans d'aboutage des tronçons. L'homme du métier comprendra qu'un graphe de routage représente en pratique un ensemble de chemins de câble dans l'aéronef.

L'objet « AcCable » représente un câble destiné à être routé au sein de l'aéronef. A chaque câble correspond un arbre de routage « AcRoute ». Réciproquement un arbre de routage peut permettre de router un ou plusieurs câbles. Un câble peut faire partie d'un chemin de câble, représenté par « AcCablePath ». On appelle chemin de câble tout ensemble de câbles connectés entre eux. Chaque câble est par ailleurs défini par ses deux extrémités représentées par « AcCableExt ». Chaque extrémité de câble possède comme attribut ses coordonnées cartésiennes en X, Y, Z par rapport au repère précité. Enfin, chaque extrémité de câble est reliée soit à une occurrence d'équipement « EquipmentOc » soit à une boîte de dérivation « DerivationPoint ». Une boîte de dérivation permet de connecter une pluralité de câbles à l'extrémité d'un câble donné. L'objet « EquipmentOc » est représenté symboliquement ici pour indiquer que l'objet « AcCableExt » hérite des attributs AC-X, AC-Y, AC-Z de l'objet « EquipmentOc », en d'autres termes les coordonnées des extrémités d'un câble sont obtenues comme celles des occurrences d'équipement que celui-ci relie.

Le modèle illustré en Fig. 5 permet de modéliser l'installation de la plateforme avionique au sein de l'aéronef.

Il permet de stocker d'une part le câblage de la plateforme avionique (partie du modèle à droite de la ligne 510) dans une base de données, dite base de données de câblage et, d'autre part, le routage au sein de l'aéronef (partie du modèle à gauche de la ligne 510), dans une base de données, dit base de données de routage.

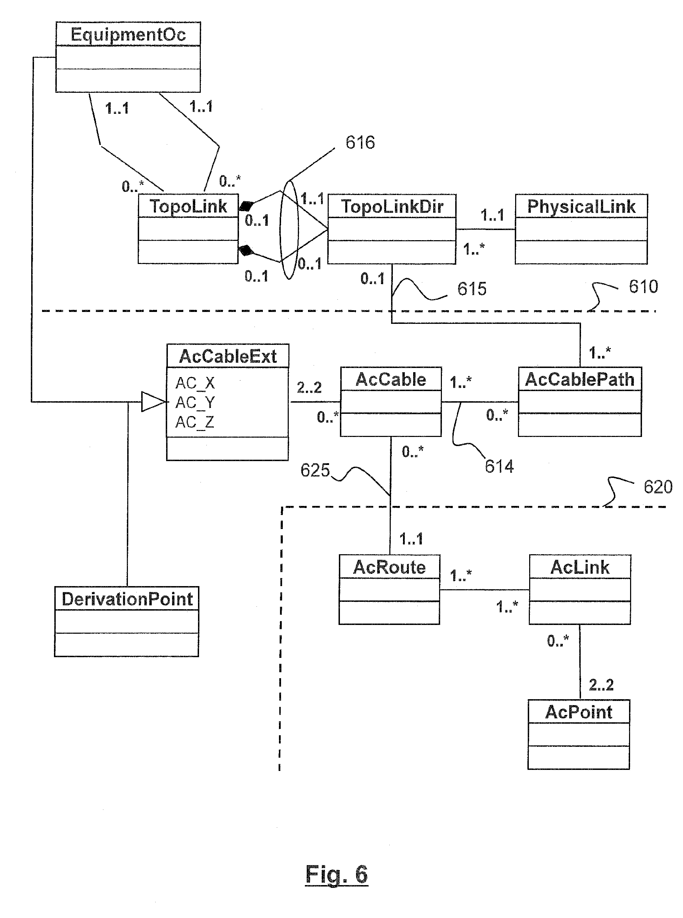

La Fig. 6 représente la correspondance entre la structure de données représentant la plateforme avionique et celle représentant son installation dans l'aéronef.

La ligne 610 délimite la représentation matérielle de plateforme avionique de celle de son installation dans l'aéronef. En particulier, la relation 615 signifie qu'à toute branche d'une liaison physique, on fait correspondre un chemin de câble. On comprendra que, dès lors qu'un lien topologique et donc qu'une branche de liaison physique associée à ce lien change ou encore dès lors qu'une position d'une occurrence d'équipement est modifiée, le câblage doit être modifié.

De manière similaire, la ligne 620 délimite la représentation du câblage de celle de son routage dans l'aéronef. En particulier, la relation 625 traduit le routage d'un câble selon un chemin de routage. Dès lors que les attributs d'un câble sont modifiés, le chemin de routage peut devoir aussi être modifié.

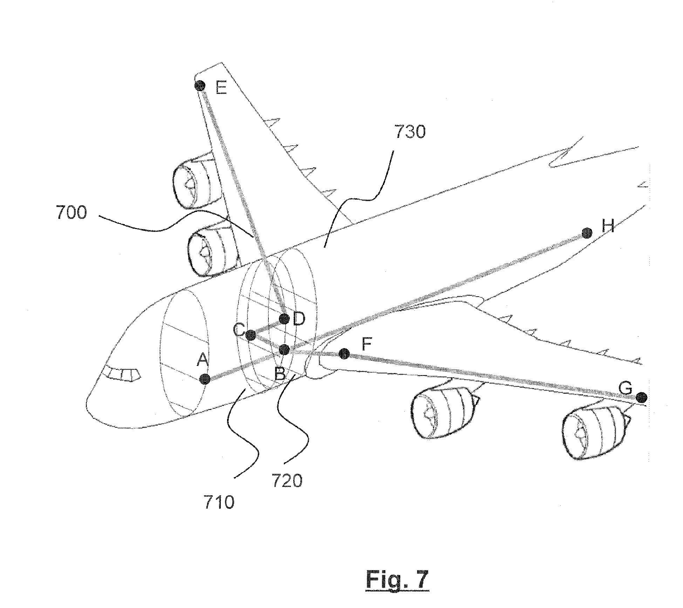

La Fig. 7 donne un exemple d'un graphe de routage dans un aéronef, en l'occurrence un arbre de routage.

Cet arbre de routage 700 permet de relier la baie avionique aux ailes et à la partie arrière de l'aéronef. Il comprend un ensemble de segments AB, BC, CD, DE, BF, FG, BH.

Tout chemin (au sens de la théorie des graphes) de l'arbre de routage définit un chemin de routage. Ainsi les ensembles $RP_1 = \{AB,BC,CD,DE\}$ ou $RP_2 = \{AB,BH\}$ ou encore $RP_3 = \{AB,BF,FG\}$ sont des chemins de routage du graphe 700.

Certaines extrémités de segment, c'est-à-dire certains sommets du graphe sont des points de coupure au sens défini plus haut, par exemple les points C et D. Le point C est à l'intersection du chemin de routage $RP_1$ avec le plan $\Pi_1$ séparant les tronçons 710 et 720 ; le point D est à l'intersection du chemin de routage $RP_2$ avec le plan $\Pi_2$ séparant les tronçons 720 et 730.

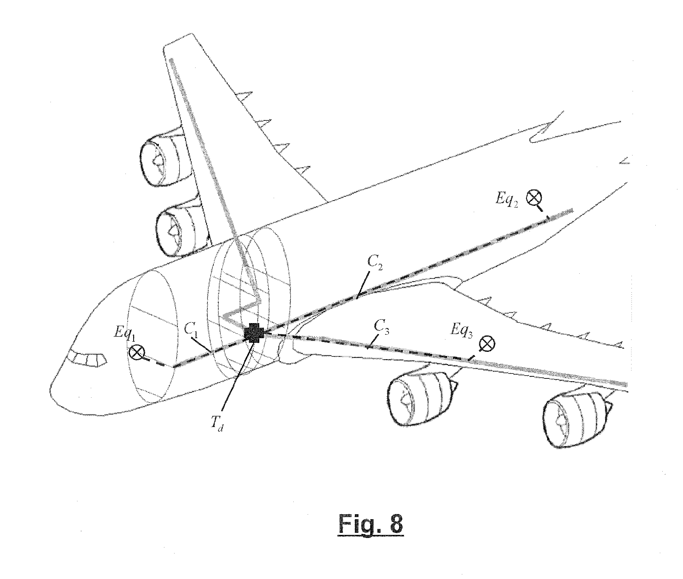

La Fig. 8 donne un exemple de chemins de câble dans un aéronef.

L'arbre de routage est supposé être le même que celui de la Fig. 7. On a représenté trois équipements $Eq_1,Eq_2,Eq_3$ reliés par trois câbles $C_1, C_2, C_3$. Les câbles $C_2, C_3$ sont connectés au câble $C_1$ grâce à la boîte de dérivation $T_d$. Ainsi, le chemin de câble $CP_1$ constitué par la concaténation des câbles $C_1$ et $C_2$, permet de relier les équipements $Eq_1$ et $Eq_2$. De même, le chemin de câble $CP_2$ constitué par la concaténation des câbles $C_1$ et $C_3$ permet de relier les équipements $Eq_1$ et $Eq_3$.

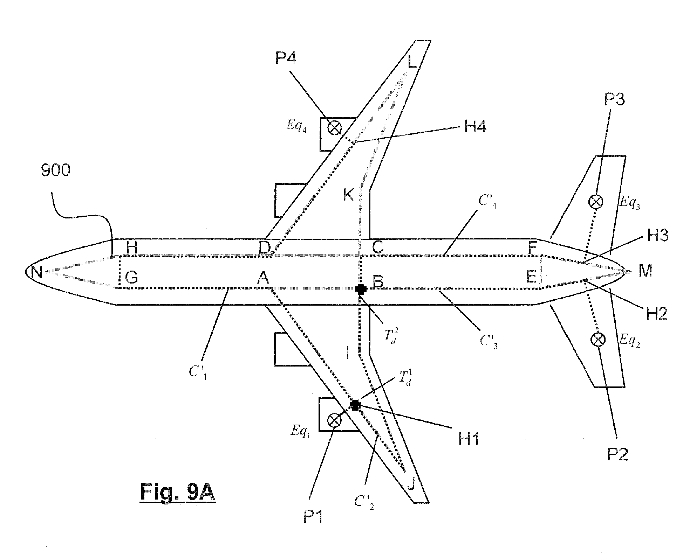

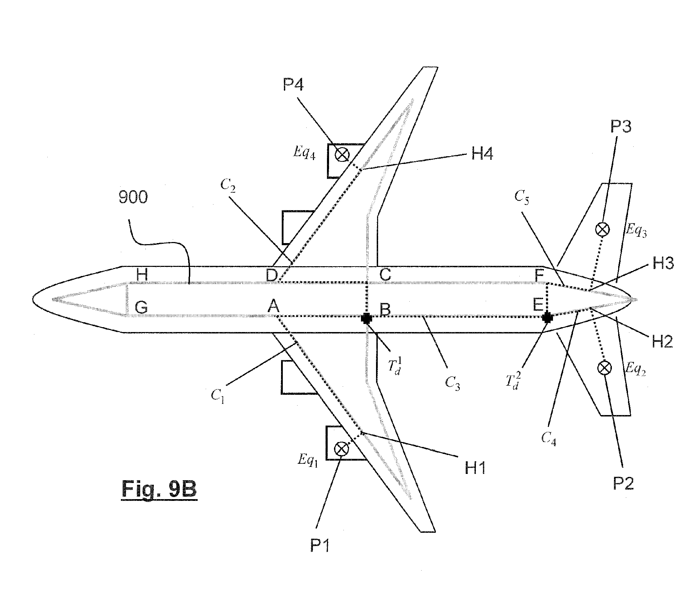

Les Figs. 9A et 9B illustrent différentes possibilités de routage pour une liaison physique entre une pluralité d'occurrences d'équipements d'une plateforme avionique.

Nous considérons ici une liaison physique reliant une occurrence d'équipement $Eq_1$ à trois autres occurrences d'équipement désignées par $Eq_2,Eq_3,Eq_4$. Cette liaison physique est associée à trois liens topologiques orientés $TL_1$, $TL_2$ et $TL_3$ partant tous de $Eq_1$ et dirigés respectivement vers $Eq_2,Eq_3,Eq_4$. A chacun de ces liens topologiques orientés correspond une branche de liaison physique, on a par conséquent trois branches $b_1$, $b_2$ et $b_3$ reliant $Eq_1$ à $Eq_2,Eq_3,Eq_4$, respectivement.

Le routage de la liaison physique consiste à affecter à chaque branche de cette liaison un chemin de routage au travers le graphe de routage 900. On a noté $A$ à $N$ les sommets des segments composant ce graphe de routage, $P_1$ à $P_4$ les points où sont situés respectivement les équipements $Eq_1$ à $Eq_4$ , et enfin $H_1$ à $H_4$ les projections orthogonales respectives des points $P_1$ à $P_4$ sur le graphe de routage. Par projection orthogonale d'un point sur le graphe de routage on entend le point du graphe le plus proche de ce point.

La Fig. 9A donne une première solution de routage. La branche $b_1$ est routée via le chemin de routage $RP_1$ défini par $RP_1 = \{P_1H_1,H_1J,JI,IB,BE,EH_2,H_2P_2\}$, la branche $b_2$ est routée via le chemin de routage $RP_2 = \{P_1H_1,H_1J,JI,IB,BC,CF,FH_3,H_3P_3\}$, et la branche $b_3$ via le chemin de routage $RP_3 = \{P_1H_1,H_1A,AG,GH,HD,DH_4,$

$H_4P_4\}$. Deux boîtes de dérivation $T_d^1$ et $T_d^2$ sont ici nécessaires et elles sont placées respectivement aux points $H_1$ et $B$ du graphe.

La Fig. 9B donne une seconde solution de routage. La branche $b_1$ est routée via le chemin de routage $RP'_1$ défini par $RP'_1 = \{P_1H_1,HA,AB,BE,EH_2,H_2P_2\}$, la branche $b_2$ est routée via le chemin de routage $RP'_2 = \{P_1H_1,H_1A,AB,BE,EF,FH_3,H_3P_3\}$ , la branche $b_3$ via le chemin de routage $RP'_3 = \{P_1H_1,H_1A,AB,BC,CD,DH_4,$

$H_4P_4\}$. Deux boîtes de dérivation $T_d^1$ et $T_d^2$ sont encore nécessaires, et sont placées cette fois aux points $B$ et $E$.

On comprendra que la solution de routage de la Fig. 9A est moins bonne que celle de la Fig. 9B en termes de longueur de câblage. A longueur de câblage identique, la meilleure solution de routage sera celle qui demandera le plus faible nombre de boîtes de dérivation, et à nombre de boîtes identique, la meilleure solution sera celle qui présente le plus faible nombre de points de coupure. On rappelle qu'un point de coupure d'un chemin de routage est à l'intersection de deux tronçons adjacents de l'aéronef. Ces tronçons sont fabriqués et câblés séparément, ce qui impose de prévoir un connecteur au niveau du point de coupure lorsqu'un chemin de câble passe par le point en question.

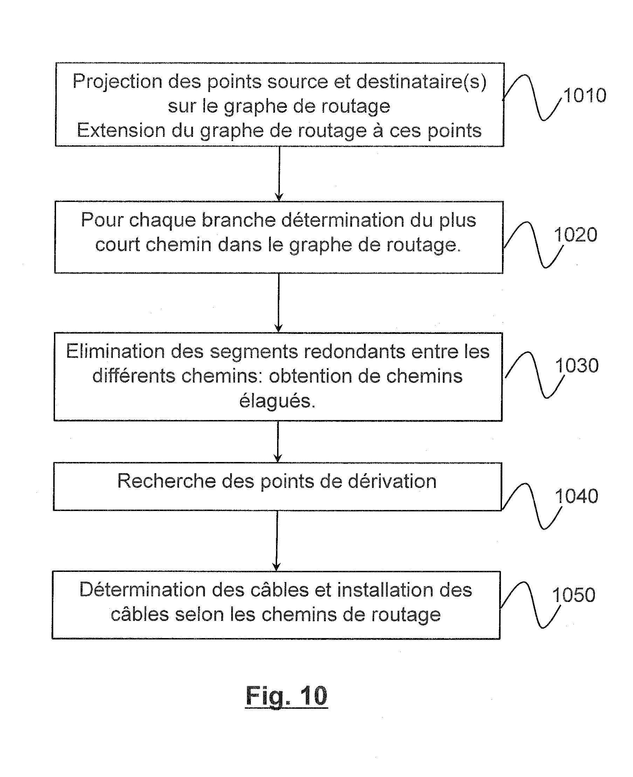

La Fig. 10 représente un organigramme de la méthode de routage selon un mode de réalisation de l'invention.

On considère ici le cas général d'une liaison physique PL composée d'une pluralité N de branches, soit $b_1,..,b_N$, chacune des branches correspondant à un lien topologique orienté, reliant deux occurrences d'équipement $Eq_i$ et $Eq_j$. On note dans la suite $P_i$ la position de l'occurrence d'équipement $Eq_i$, $i=1,...,neq$ où $neq$ est le nombre d'occurrences d'équipement considérées.

On part de l'hypothèse que l'on connaît le graphe de routage RG associé à la liaison physique PL.

Dans une première étape 1010, on projette chacun des points $P_i$ sur le graphe de routage $RG$. On obtient ainsi un ensemble de points $H_i$ appartenant à des arêtes du graphe. On étend le graphe de routage RG en y adjoignant les segments $H_iP_i$, $i=1,..,neq$. Soit

$$RG^+ = RG \bigcup_{i=1}^{neq} H_iP_i$$ le graphe ainsi étendu.

A l'étape 1020, on détermine pour chaque branche $b_n$, le plus court chemin dans le graphe étendu $RG^+$

permettant de relier les points $P_i$ et $P_j$. On pourra utiliser à cet effet l'algorithme de Dijkstra, bien connu en soi, en affectant à chaque arête du graphe, la longueur du segment correspondant. Chaque branche $b_n$ est par conséquent associée à une liste ordonnée de segments, le premier segment étant nécessairement $P_iH_i$ et le dernier segment $P_jH_j$.

A l'étape 1030, on procède à l'élimination des segments redondants entre les chemins ainsi obtenus. Plus précisément, si un segment est présent en plusieurs exemplaires, on ne garde qu'un seul représentant de ce segment parmi les différents chemins. On obtient ainsi un ensemble connexe de chemins élagués, chaque chemin élagué étant constitué par un ensemble ordonné de segments.

A l'étape 1040, on identifie parmi les segments des différents chemins élagués, ceux qui partagent une extrémité. Un point constituant une extrémité d'au moins deux segments appartenant à des chemins élagués distincts est appelé point de dérivation. Ces points sont les lieux où seront installées les boîtes de dérivation. Alternativement, et de manière équivalente, les points de dérivation sont obtenus comme les extrémités communes à au moins trois segments de l'ensemble des chemins élagués.

A l'étape 1050, on effectue les routages respectifs de câbles.

Pour ce faire, on considère chaque chemin élagué associé et l'on parcourt le chemin dans le sens de la branche associée à ce chemin.

On concatène les segments à partir du premier de la liste jusqu'à ce que l'on arrive, soit à un point de dérivation, soit à l'extrémité de la branche, c'est-à-dire le point où se trouve l'occurrence d'équipement destinataire. On définit un premier câble comme l'ensemble des segments ainsi concaténés.

Si l'on n'a pas atteint l'extrémité de la branche, on effectue une nouvelle opération de concaténation de segments en partant du premier segment du chemin élagué non encore concaténé, jusqu'à ce que l'on arrive à nouveau à un point de dérivation ou à l'extrémité de la branche en question. On définit un nouveau câble comme l'ensemble des segments concaténés par cette nouvelle opération de concaténation.

On procède de proche en proche, jusqu'à épuisement des segments du chemin élagué, c'est-à-dire jusqu'à ce que l'on atteigne l'extrémité de la branche en question.

On définit ainsi pour chaque chemin élagué un ensemble de câbles, une extrémité d'un câble étant connectée soit à une occurrence d'équipement, soit à une boîte de dérivation. On peut identifier chaque câble par une référence et associer à cette référence une sous-liste de segments du chemin de routage dont il est issu. Cette association est représentée en Fig. 6 par la relation 625. Chaque câble ainsi défini est alors installé dans l'aéronef selon le chemin de routage ainsi déterminé.

Si l'on considère maintenant à nouveau une branche de la liaison physique et que l'on substitue dans la liste ordonnée de segments constitutive du chemin de routage correspondant à cette branche, chaque sous-liste de segments relative à un câble, par la référence du câble en question, on obtient une liste de références de câbles. On associe ainsi à chaque branche une liste de câbles connectés bout à bout, autrement dit un chemin de câble reliant l'occurrence d'équipement source à l'occurrence d'équipement destinataire de la branche. Cette association est représentée en Fig. 6 par la relation 615.

Chacun des câbles étant routé dans l'aéronef, on comprendra que la branche de liaison physique est également routée.

On peut ainsi router toutes les branches d'une liaison physique et donc la liaison physique elle-même, en partant d'un graphe de routage et de positions d'occurrences d'équipement donnés.

La méthode de routage selon l'invention peut également être utilisée pour déterminer les positions optimales des occurrences d'équipement permettant de minimiser, à graphe de routage constant, les distances de câblage. A cette fin, l'opération de routage est répétée pour différentes positions des occurrences d'équipement. Les solutions de câblage et/ou les distances de câblage sont ensuite comparées.

Alternativement, la méthode de routage peut être utilisée pour tester plusieurs graphes de routage possibles, à positions constantes d'occurrences d'équipement. Les solutions de routage et/ou les distances de câblage sont comparées pour les différents graphes.

Enfin, la méthode de routage peut permettre d'évaluer l'installation existante d'une plateforme avionique en calculant par exemple l'écart entre la distance de câble réelle et la distance de câblage optimale.

En pratique la méthode de routage selon l'invention est mise en oeuvre par un programme d'ordinateur. Chaque graphe de routage est défini par ses extrémités (ou noeuds) et par ses arêtes. Chaque extrémité du graphe est définie par ses coordonnées spatiales et chaque arête par le couple d'extrémités qu'elle relie.

De manière similaire chaque liaison physique est définie par un ensemble de branches, chaque branche étant définie par le couple d'équipements (plus précisément le couple d'occurrences d'équipement) qu'elle relie. On rappelle que chaque occurrence d'équipement a entre autres pour attribut les coordonnées spatiales où elle est située. On rappelle que les graphes de routage sont stockés dans la base de données de routage, notée $DBR$ et que les liaisons physiques sont stockées dans la base de données matérielle, notée $DBL$.

A partir ces deux bases de données le programme de routage construit une base de données de câblage fournissant pour chaque branche de liaison physique, un chemin de câble, et une base de données de routage fournissant pour chaque câble du chemin de câble un chemin de routage comme indiqué précédemment.

Nous illustrerons ci-après la méthode de routage selon l'invention à l'aide de l'exemple de la Fig. 9B.

La liaison physique PL à router est constituée d'une branche $b_1$ reliant $P_1$ à $P_2$, d'une branche $b_2$ reliant $P_1$ à $P_3$ et d'une branche $b_3$ reliant $P_1$ à $P_4$.

On projette les points $P_1$ à $P_3$ sur le graphe de routage en question et l'on obtient ainsi les points $H_1$ à $H_3$. On étend le graphe de routage en y adjoignant les segments $P_1H_1$, $P_2H_2$ et $P_3H_3$.

Les chemins les plus courts sont déterminés pour chaque branche, par exemple au moyen de l'algorithme de Dijkstra, soit

$$\text{pour } b_1 \quad : P_1H_1, H_1A, AB, BE, EH_2, H_2P_2$$
$$\text{pour } b_2 \quad : P_1H_1, H_1A, AB, BE, EF, FH_3, H_3P_3$$
$$\text{pour } b_3 \quad : P_1H_1, H_1A, AB, BC, CD, DH_4, H_4P_4$$

On élimine ensuite les segments redondants entre les différents chemins de routage, on obtient alors les chemins élagués :

$$\text{pour } b_1 \quad : P_1H_1, H_1A, AB, BE, EH_2, H_2P_2$$
$$\text{pour } b_2 \quad : EF, FH_3, H_3P_3$$
$$\text{pour } b_3 \quad : BC, CD, DH_4, H_4P_4$$

On détermine les extrémités communes à au moins deux segments appartenant à des chemins élagués distincts. On obtient ainsi comme points de dérivation :

- l'extrémité $E$ commune aux segments $BE$ et $EF$;
- l'extrémité $B$ commune aux segments $AB$ et $BC$.

Alternativement on peut déterminer les points de dérivation comme ceux appartenant à au moins trois segments, sans considération de chemins élagués distincts. En effet :

- l'extrémité $E$ commune aux segments $BE, EF, EH_2$;
- l'extrémité $B$ commune aux segments $AB$ , $BC$ , $BE$ ;

On effectue ensuite le processus de concaténation de segments pour le chemin (non élagué) associé à $b_1$. On détermine ainsi trois câbles :

$$C_1 : \quad P_1H_1, H_1A, AB$$
$$C_2 : \quad BE$$
$$C_3 : \quad EH_2, H_2P_2$$

Le processus de concaténation donne ensuite, pour $b_2$, le câble

$$C_4 : \quad EF, FH_3, H_3P_3$$

et enfin, pour $b_3$, le câble

$$C_5 : \quad BC, CD, DH_4, H_4P_4$$

Il suffit alors de substituer dans les chemins de routage, les sous-listes de segments par les références des câbles pour obtenir les chemins de câble :

$$\text{pour } b_1 \quad : C_1, C_2, C_3$$
$$\text{pour } b_2 \quad : C_1, C_2, C_4$$
$$\text{pour } b_3 \quad : C_1, C_5.$$

Une fois le routage effectué, il est possible de déterminer la robustesse de la plateforme avionique vis à vis d'un accident éventuel par exemple l'explosion d'un moteur, l'explosion d'une roue, l'impact d'un oiseau.

Pour chaque type d'accident on sait déterminer par simulation et/ou expérience les éléments physiques de l'aéronef qui peuvent être endommagés en fonction de leurs positions dans l'aéronef. Par exemple, on peut déterminer quels câbles ou quelles occurrences d'équipement sont susceptibles d'être endommagés pour un accident donné. Il est alors important de connaître les fonctions avioniques qui sont affectées par l'accident en question.

Selon un mode particulier de réalisation de l'invention, la modélisation de l'implémentation de la plateforme avionique dans l'aéronef, telle qu'illustrée en Fig. 6 permet avantageusement de déduire des éléments physiques impactés par l'accident les fonctions avioniques qui sont affectées.

On obtient par simulation numérique, à l'aide d'une maquette tridimensionnelle de l'aéronef, la liste des points du ou des graphes de routage qui sont impactés par l'accident. Plus précisément, on détermine pour chaque segment du graphe de routage, la liste des points, dits points de rupture, impactés par l'accident en question. On peut en déduire, grâce au modèle de données de la Fig. 6, l'ensemble $CAB\_L$ des câbles impactés, un câble étant considéré comme impacté dès lors qu'il passe par un segment « AcLink » comprenant un point de rupture. On détermine d'autre part un ensemble $EQ\_L$ d'occurrences d'équipement impactées par l'accident.

Selon le modèle de données de la Fig. 6 (voir 614 en Fig. 6), on sait déterminer pour chaque câble de $CAB\_L$, les chemins de câble qui l'incluent et sont par conséquent eux-mêmes affectés. Soit $CAB\_PATH\_L$ l'ensemble des chemins de câble affectés par la perte des câbles de $CAB\_L$.

On peut en déduire ensuite (voir 615 et 616 en Fig. 6) la liste des liens topologiques qui sont affectés par la perte des chemins de câble de $CAB\_PATH\_L$. Soit $TL\_L$ la liste de ces liens topologiques.

On déduit (via les relations 419 en Fig. 4) de la perte des liens topologiques de $TL\_L$ l'ensemble $PATH\_L$ des chemins topologiques (représentés par « Path ») affectés par l'accident.

On construit enfin l'ensemble $FOL\_L$ des occurrences de liens fonctionnels (modélisés par « FctLinkOc ») affectées :

- soit par la perte d'un chemin topologique correspondant (via la relation 420 en Fig. 4) de *TL_L;*
- soit par la perte d'un module logiciel (via la relation 401) hébergé par une occurrence d'équipement appartenant à *EQ_L* (via la relation 410).

L'ensemble *FO_Z* des modules logiciels (modélisés par « SystemF'unctionOc ») hébergés par les occurrences d'équipement appartenant à *EQ_L,* ainsi que l'ensemble *FOL_L* des occurrences de liens fonctionnels affectés permettent de décrire complètement l'impact de l'accident en termes de fonctions avioniques.

Si le routage choisi et/ou le placement choisi pour les occurrences d'équipement ne permet/permettent pas d'obtenir la robustesse fonctionnelle désirée, une nouvelle tentative de routage et/ou de placement des occurrences d'équipement dans l'aéronef est effectuée.

**Revendications**

1. Méthode de routage par ordinateur d'une liaison physique d'une plateforme avionique à l'intérieur d'un aéronef, ladite liaison physique reliant une pluralité (N) d'équipements physiques et étant composée d'une ou plusieurs branche(s), chaque branche de ladite liaison reliant un équipement source à un équipement destinataire de ladite pluralité, **caractérisée en ce que :**

    - les positions des équipements source et destinataire sont projetées orthogonalement (1010) sur au moins un graphe de routage prédéterminé au sein de l'aéronef et l'on étend ce graphe aux points définis par ces positions, par leurs projections respectives sur le graphe et par des liaisons entre les premiers et les seconds ;
    - on détermine (1020), pour chaque branche de ladite liaison, le chemin le plus court, à travers le graphe ainsi étendu, entre les équipements source et destinataire qu'elle relie, ledit chemin, dit chemin de routage, étant défini par une liste ordonnée de segments entre ces équipements ;
    - on élimine (1030) les segments redondants entre les chemins de routage pour obtenir des chemins élagués, un segment redondant étant défini comme appartenant à au moins deux chemins de routage ;
    - on détermine des points de dérivation comme les extrémités de segment communes à aux moins trois segments desdits chemins élagués (1040) ;
    - on définit (1050) à partir de chaque chemin élagué un ensemble de câbles dont les extrémités sont situées soit en un point d'équipement soit en un point de dérivation, lesdits câbles étant routés selon le chemin de routage.

2. Méthode de routage selon la revendication 1, **caractérisée en ce que** les câbles sont définis en concaténant, pour chaque chemin élagué, les segments qui le constituent, l'opération de concaténation progressant dans le sens de la branche et étant interrompue à chaque fois que l'on atteint un point de dérivation ou bien un équipement destinataire, un câble étant défini par les segments concaténés entre deux interruptions successives.

3. Méthode de routage selon l'une des revendications précédentes, **caractérisée en ce que,** pour chaque branche, le chemin le plus court, au sein du graphe de routage, entre l'équipement source et l'équipement destinataire est obtenu par l'algorithme de Dijkstra.

4. Méthode de routage selon l'une des revendications précédentes, **caractérisée en ce qu'**elle utilise :

    - une première base de données, dans laquelle est stockée une représentation d'au moins ledit graphe de routage, ledit graphe de routage étant défini par ses sommets et par les arêtes qui relient ces sommets ;
    - une seconde base de données, dans laquelle est stockée une représentation des liaisons physiques de la plateforme avionique et, pour chaque liaison physique, des différentes branches qui la composent.

5. Méthode de routage selon la revendication 4, **caractérisée en ce qu'**elle stocke dans une troisième base de données une représentation des câbles reliant les équipements, et dans une quatrième base de données, le chemin de routage associé à chaque câble.

6. Méthode de routage selon la revendication 5, **caractérisée en ce qu'**elle stocke en outre une représentation desdits points de dérivation.

7. Méthode de routage selon la revendication 5, **caractérisée en ce que** la première base de données comprend en outre une représentation des points de coupure, un point de coupure étant défini comme l'intersection d'un chemin de routage avec le plan d'aboutage de deux tronçons consécutifs composant l'aéronef.

8. Méthode de routage selon l'une des revendications précédentes, **caractérisée en ce qu'**elle est effectuée pour toutes les liaisons physiques de la plateforme avionique et que l'on calcule une longueur totale de câblage comme la somme des longueurs des câbles obtenus pour toutes les liaisons physiques, la longueur d'un câble étant déterminée comme la somme des longueurs des segments qui le constituent.

9.  Méthode de routage selon la revendication 8, **caractérisée en ce qu'**elle est répétée pour différentes positions des équipements, et que l'on sélectionne l'ensemble des positions de ces équipements qui conduisent à la plus faible longueur totale de câblage.

10. Méthode de routage selon la revendication 8, **caractérisée en ce qu'**elle est répétée pour différents graphes de routage, et que l'on sélectionne le graphe de routage qui conduit à la plus faible longueur totale de câblage.

11. Méthode de routage selon les revendications 7 et 8, **caractérisée en ce qu'**elle est répétée pour différentes positions des équipements et/ou différents graphes de routage, et que l'on sélectionne l'ensemble des positions de ces équipements et/ou le graphe de routage qui conduisent au plus faible nombre de points de coupure.

12. Méthode de routage selon l'une des revendications précédentes, **caractérisée en ce que** l'on simule un accident de l'aéronef et que l'on détermine une première liste de câbles (*CAB_L*) impactés par cet accident, à partir des points du graphe de routage eux-mêmes impactés, et/ou une seconde liste d'équipements (*EQ_L*) impactés par cet accident et que l'on déduit :

      - un premier ensemble (*FO_L*) de modules logiciels hébergés par lesdits équipements de la seconde liste ;
      - un second ensemble (*FLO_L*) de liens fonctionnels entre modules logiciels, lesdits liens fonctionnels étant affectés soit en raison d'un module logiciel auquel ils sont reliés, appartenant au premier ensemble, soit en raison d'un câble de la première liste supportant une liaison topologique utilisée par lesdits liens fonctionnels.

**Fig. 1**

**Fig. 2**

Fig. 3A

Fig. 3B

Fig. 3C

**Fig. 4**

**AcRoute** 1..1 ——— 0..* **AcCable** 1..* ——— **AcCablePath**

0..*

1..*

1..*

**AcLink**

0..*

2..2

**AcPoint**

**CutPoint**

0..*

2..2

**AcCableExt**

0..1

**DerivationPoint**

0..1

**EquipmentOc**

510

**Fig. 5**

**Fig. 6**

**Fig. 7**

**Fig. 8**

**Fig. 9A**

**Fig. 9B**

Projection des points source et destinataire(s)
sur le graphe de routage
Extension du graphe de routage à ces points
1010

Pour chaque branche détermination du plus
court chemin dans le graphe de routage.
1020

Elimination des segments redondants entre les
différents chemins: obtention de chemins
élagués.
1030

Recherche des points de dérivation
1040

Détermination des câbles et installation des
câbles selon les chemins de routage
1050

**Fig. 10**

# EP 2 278 504 A1

Europäisches
Patentamt

European
Patent Office

Office européen
des brevets

## RAPPORT DE RECHERCHE EUROPEENNE

Numéro de la demande

EP 10 16 9331

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | WO 02/23688 A2 (BOEING CO [US]) 21 mars 2002 (2002-03-21) * le document en entier * * figures 2,3 * ----- | 1-12 | INV. G06F17/50 |
| A | ALENA R L ET AL: "Communications for Integrated Modular Avionics" AEROSPACE CONFERENCE, 2007 IEEE, IEEE, PISCATAWAY, NJ, USA, 3 mars 2007 (2007-03-03), pages 1-18, XP031214239 ISBN: 978-1-4244-0524-4 * le document en entier * ----- | 1-12 | |

DOMAINES TECHNIQUES
RECHERCHES (IPC)

G06F

Le présent rapport a été établi pour toutes les revendications

| Lieu de la recherche | Date d'achèvement de la recherche | Examinateur |
|---|---|---|
| Munich | 6 août 2010 | Wellisch, J |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
 
& : membre de la même famille, document correspondant

EPO FORM 1503 03.82 (P04C02)

23

**ANNEXE AU RAPPORT DE RECHERCHE EUROPEENNE
RELATIF A LA DEMANDE DE BREVET EUROPEEN NO.**

EP 10 16 9331

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-08-2010

| Document brevet cité au rapport de recherche | | Date de publication | Membre(s) de la famille de brevet(s) | | Date de publication |
|---|---|---|---|---|---|
| WO 0223688 | A2 | 21-03-2002 | AU | 8904201 A | 26-03-2002 |
| | | | US | 2003047997 A1 | 13-03-2003 |

Pour tout renseignement concernant cette annexe : voir Journal Officiel de l'Office européen des brevets, No.12/82